# EUROPEAN PATENT APPLICATION

(11) **EP 1 684 326 A2**
(43) Date of publication of application: **26.07.2006**
(21) Application number: 06001325.7
(22) Date of filing: 23.01.2006
(51) Int. Cl.: H01J 29/00, H01J 17/18, H01J 17/34

(54) **Heat dissipation sheet for flat display apparatus and flat display apparatus including the same**

(30) Priority: 21.01.2005 KR 2005005978
(71) Applicant: LG Electronics Inc., Yongdungpo-gu Seoul (KR)
(72) Inventor: Kong, Junhee, Gumi-si Gyeongsangbuk-do (KR); Kwak, Hocheol, Hwaseong-si Gyeonggi-do (KR); Bae, Kwangbae, Gumi-si Gyeongsangbuk-do (KR)
(74) Representative: Beyer, Andreas

(57) **Abstract**

A heat dissipation sheet for a flat display apparatus and a flat display apparatus including the same are provided. The flat display apparatus comprises a display panel, a frame formed on a rear surface of the display panel, and a heat dissipation sheet including a metal mixture and an adhesive, formed between the display panel and the frame.

## Description

### BACKGROUND OF THE INVENTION

### Field of the Invention

The present invention relates to a heat dissipation sheet for a flat display apparatus and a flat display apparatus including the same.

### Description of the Background Art

Generally, a flat display apparatus comprises a liquid crystal display (LCD), a filed emission display (FED), an organic electroluminescence panel (EL), a plasma display apparatus, and the like. Particularly, in the plasma display apparatus, when an inert gas existing between a front substrate and a rear substrate which are made of soda-lime glass is discharged by a high frequency voltage, vacuum ultraviolet rays are radiated and phosphors formed in the plasma display apparatus are light-emitted by the vacuum ultraviolet rays. As a result, images are implemented.

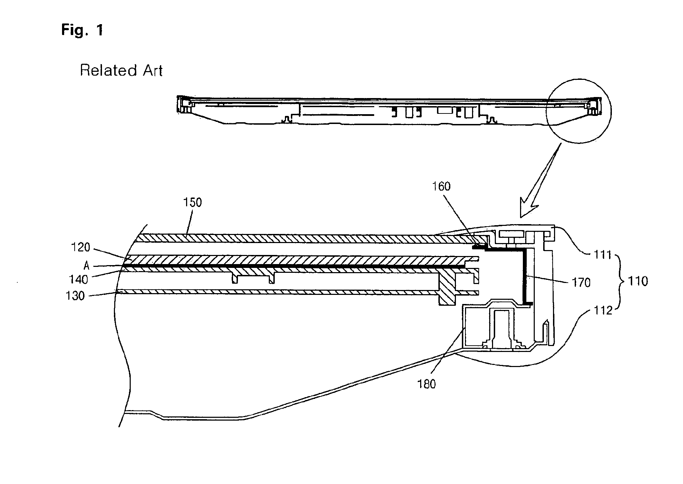

FIG. 1 schematically shows a structure of a related art plasma display apparatus.

As shown in FIG. 1, a plasma display apparatus comprises a case 110 including a front cabinet 111 and a back cover 112 for forming a shape of the plasma display apparatus, a plasma display panel 120 where vacuum ultraviolet rays generated by a discharge of a gas existing in the case 110 excite phosphors, thereby displaying images, a driving section 130 which comprises a printed circuit board to drive and control the plasma display panel 120, a frame 140 which is connected to the driving section 130, dissipates heat generated by driving the plasma display apparatus and supports the plasma display panel 120, and a heat dissipation sheet A which is formed between the plasma display panel 120 and the frame 140 and transmits heat generated from the plasma display panel 120 to the frame 140.

Further, the plasma display apparatus comprises a filter 150 which is formed on a front surface of the plasma display panel 120 and spaced a give distance from the plasma display panel 120 by adhering a film on a transparent glass substrate, a finger spring gasket 160 which supports the filter 150 and electrically connects the filter 150 to the back cover 112, and a module supporter 180 which supports a filter supporter 170 and the plasma display apparatus including the driving section 130.

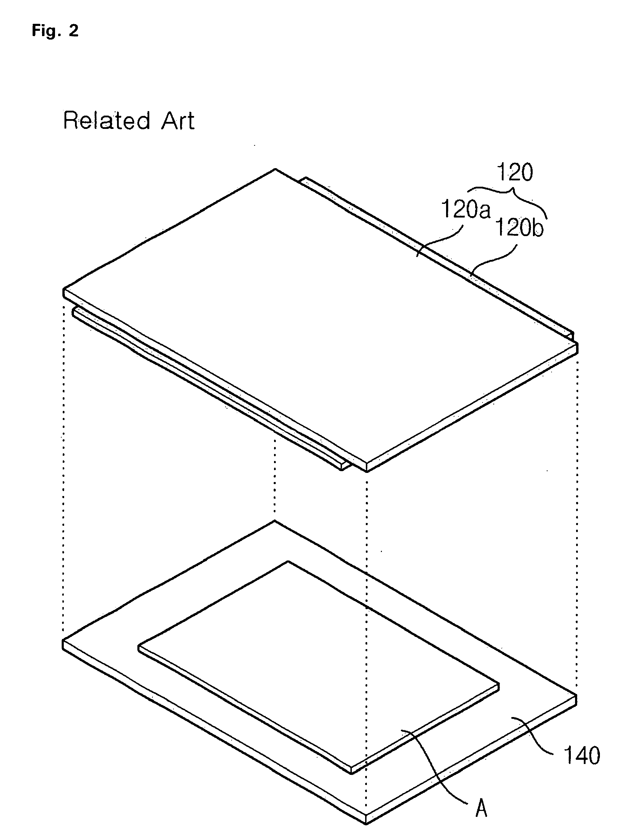

FIG. 2 schematically shows a heat dissipation sheet of the related art plasma display apparatus shown in FIG. 1.

As shown in FIG. 2, the heat dissipation sheet A is formed on the frame 140, and then adhered to the plasma display panel 120. That is, the frame 140 is adhered to the plasma display panel 120 comprising a front substrate 120a and a rear substrate 120b by the heat dissipation sheet A. Heat generated by driving the plasma display panel 120 is transmitted to the frame 140 through the heat dissipation sheet A. Further, the frame 140 is adhered to the plasma display panel 120 by the heat dissipation sheet A, supports the plasma display panel 120, and dissipates heat transmitted through the heat dissipation sheet A to the outside.

However, there is a problem in that heat dissipating efficiency of the heat dissipation sheet for dissipating the heat generated by driving the plasma display panel to the outside is low, which causes misdischarge in the plasma display panel.

Further, if heat generated by driving the plasma display panel is not sufficiently dissipated to the outside of the plasma display panel, the driving section for driving the plasma display panel is damaged due to the heat. This causes a reduction in the quality of the plasma display apparatus.

The reduction in heat dissipating efficiency of the heat dissipation sheet is a problem of not only the above-described plasma display apparatus but other flat display apparatuses that includes a heat dissipation sheet.

### SUMMARY OF THE INVENTION

Accordingly, an object of the present invention is to solve at least the problems and disadvantages of the background art.

The present invention provides a heat dissipation sheet for a flat display apparatus capable of efficiently dissipating heat generated by driving the flat display apparatus and a flat display apparatus including the same.

According to one aspect of the present invention, there is provided a heat dissipation sheet for a flat display apparatus comprising a metal mixture and an adhesive.

According to another aspect of the present invention, there is provided a flat display apparatus comprising a display panel, a frame formed on a rear surface of the display panel, and a heat dissipation sheet including a metal mixture and an adhesive, formed between the display panel and the frame.

According to still another aspect of the present invention, there is provided a flat display apparatus comprising a display panel, a frame formed on a rear surface of the display panel, and a heat dissipation sheet including a graphite layer and an adhesive layer, formed between the display panel and the frame.

The present invention can prevent a misoperation of a flat display apparatus by increasing heat dissipating efficiency of a heat dissipation sheet.

### BRIEF DESCRIPTION OF THE DRAWINGS

The accompany drawings, which are included to provide a further understanding of the invention and are incorporated in and constitute a part of this specification, illustrate embodiments of the invention and together with the description serve to explain the principles of the invention. In the drawings:

FIG. 1 schematically shows a structure of a related art plasma display apparatus;

FIG. 2 schematically shows a heat dissipation sheet of the related art plasma display apparatus shown in FIG. 1;

FIG. 3 shows a plasma display apparatus comprising a heat dissipation sheet of a flat display apparatus according to an embodiment of the present invention;

FIG. 4 shows the heat dissipation sheet of the plasma display apparatus of the flat display apparatus according to an embodiment of the present invention; and

FIG. 5 shows a heat dissipation sheet of a plasma display apparatus of a flat display apparatus according to another embodiment of the present invention.

### DETAILED DESCRIPTION OF PREFERRED EMBODIMENTS

Reference will now be made in detail to embodiments of the present invention, examples of which are illustrated in the accompanying drawings.

A flat display apparatus according to the present invention comprises a display panel, a frame formed on a rear surface of the display panel, and a heat dissipation sheet including a metal mixture and an adhesive, formed between the display panel and the frame.

The metal mixture comprises silicon resin and a conductive material.

A composition ratio of the conductive material ranges from 10% to 50% of a total composition ratio of the heat dissipation sheet.

The conductive material comprises one or more of Cu, Ag, Ti, Zn, Cr, Al and Au.

The metal mixture comprises urethane resin and a conductive material

A composition ratio of the conductive material ranges from 10% to 50% of a total composition ratio of the heat dissipation sheet.

The conductive material comprises one or more of Cu, Ag, Ti, Zn, Cr, Al and Au.

The resistance of the heat dissipation sheet ranges from 10Ω to 50Ω.

A flat display apparatus according to the present invention comprises a display panel, a frame formed on a rear surface of the display panel, and a heat dissipation sheet including a graphite layer and an adhesive layer, formed between the display panel and the frame.

The resistance of the heat dissipation sheet ranges from 10Ω to 50Ω.

A heat dissipation sheet for a flat display apparatus according to the present invention comprises a metal mixture and an adhesive.

Hereinafter, exemplary embodiments of the present invention will be described in detail with reference to the attached drawings.

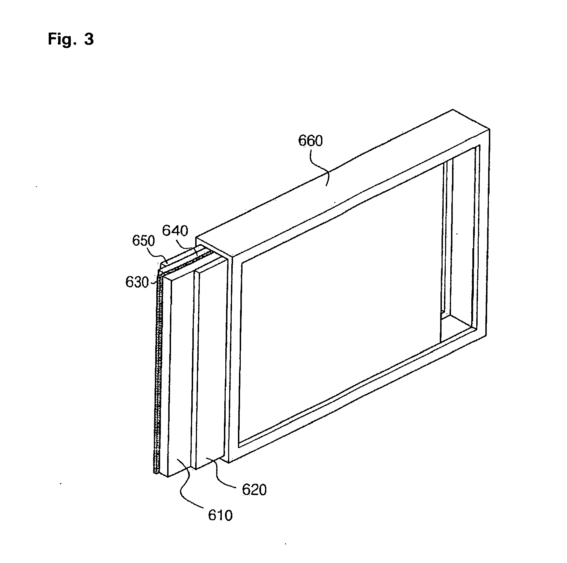

FIG. 3 shows a plasma display apparatus including a heat dissipation sheet of a flat display apparatus according to one embodiment of the present invention.

As shown in FIG. 3, a plasma display apparatus comprises a plasma display panel 610 for displaying an image, a functional filter 620 having an electro magnetic shielding function, a reflecting prevention function of external light, and the like, in a front surface of the plasma display panel 610, a heat dissipation sheet 630 for dissipating heat generated by driving the plasma display apparatus to a back surface thereof, a frame 640 formed on the back surface of the heat dissipation sheet 630, a driving circuit substrate 650 formed on a back surface of the frame 640, and a set 660 for forming a shape of the plasma display apparatus.

The plasma display panel 610 comprises a front substrate (not shown) and a rear substrate (not shown) which are coupled to each other at a given distance.

The functional filter 620 is formed as a film type and adhered to the front surface of the plasma display panel 610 by a laminating method and many other methods.

The heat dissipation sheet 630, like the functional filter 620, is adhered to the plasma display panel 610 or the frame 640 by a laminating method and many other methods. The plasma display panel 610 is adhered to the frame 640 by the heat dissipation sheet 630, and at the same time, heat generated by driving the plasma display apparatus is transmitted to the frame 640 through the heat dissipation sheet 630.

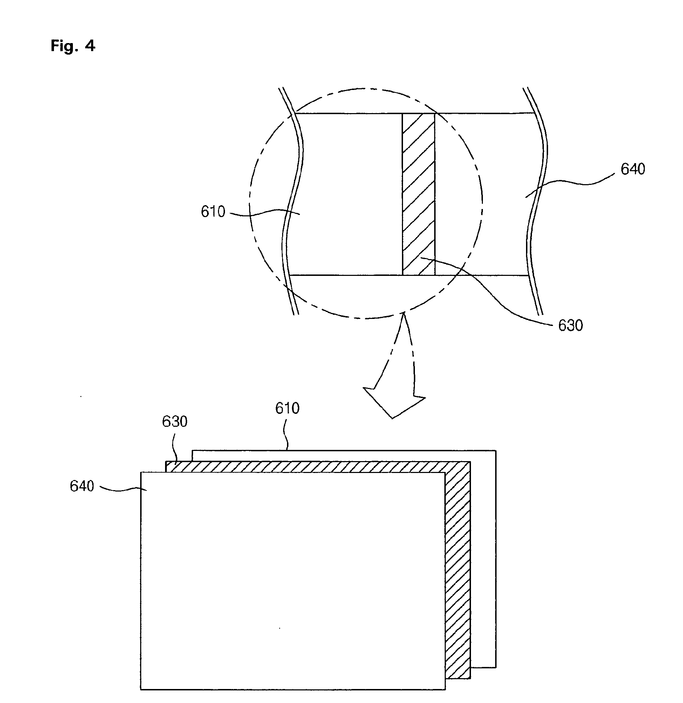

FIG. 4 shows the heat dissipation sheet of the plasma display apparatus of the flat display apparatus according to one embodiment of the present invention.

As shown in FIG. 4, the heat dissipation sheet 630 of the plasma display apparatus according to one embodiment of the present invention is formed between the plasma display panel 610 and the frame 640. The heat dissipation sheet 630 has a flexible shape and comprises an adhesive for adhering the plasma display panel 610 to the frame 640 and a metal mixture for efficiently dissipating heat generated by driving the plasma display apparatus.

The adhesive and the metal mixture in the heat dissipation sheet 630 each may be formed as the form of a layer. That is, one metal mixture layer may be formed using the metal mixture and the adhesive may be formed on an upper surface and a lower surface of the metal mixture layer as an adhesive layer, respectively.

Various materials can be used as a material of the metal mixture. However, the metal mixture comprising silicon resin and a conductive material or the metal mixture comprising urethane resin and a conductive material are preferable.

Silicon resin has a chemically thermal oxidization stability even at a high temperature and is excellent in water-resistance and an electrical insulating property. Thus, if silicon resin is mixed with a highly conductive material, the heat dissipating efficiency of the heat dissipation sheet 630 increases.

Since urethane resin, like silicon resin, has a chemically thermal oxidization stability even at a high temperature and is excellent in water-resistance, an electrical insulating property and adhesiveness, urethane resin is suitable as a sealing material.

Any materials having a thermally conductive characteristic can be used as the conductive material. However, it is preferable that the conductive material comprises one or more of Cu, Ag, Ti, Zn, Cr, Al and Au.

It is preferable that a composition ratio of the conductive material in both the metal mixture including silicon resin and the conductive material and the metal mixture including urethane resin and the conductive material ranges from 10 % to 50 % of a composition ratio of the heat dissipation sheet 630.

The conductive material is selected so that a total resistance of the heat dissipation sheet 630 ranges from 10 Ω to 50 Ω. The reason for the selected total resistance range is that if the composition ratio of the conductive material added to the heat dissipation sheet 630 exceeds 50 % and a resistance of the conductive material exceeds 50 Ω, an adhesive strength between the plasma display panel 610 and the frame 640 decreases. Moreover, a large amount of heat generated by driving the plasma display apparatus does not dissipate efficiently to the frame 640 through the heat dissipation sheet 630 due to the relatively high resistance of the conductive material.

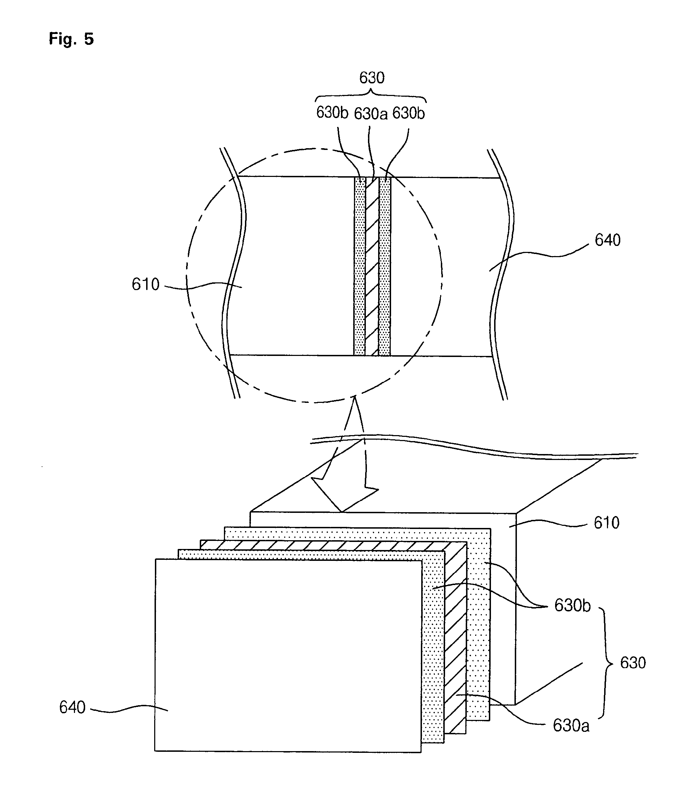

FIG. 5 shows a heat dissipation sheet of a plasma display apparatus of a flat display apparatus according to another embodiment of the present invention.

As shown in FIG. 5, a heat dissipation sheet 630 of a plasma display apparatus according to another embodiment of the present invention, as in FIG. 4, is formed between a plasma display panel 610 and a frame 640. The heat dissipation sheet 630 comprises graphite and an adhesive, which are formed as the form of a layer, respectively. More specifically, one graphite layer 630a is formed using graphite and the adhesive is formed on an upper surface and a lower surface of the graphite layer 630a as an adhesive layer 630b, respectively.

The graphite layer 630a is a mineral belong to the hexagonal system in the form of carbon and chemicalky stable. Therefore, the graphite layer 630a possesses an excellent thermal oxidization stability and a heat-resistant property even at a high temperature.

The conductive material is selected so that a total resistance of the heat dissipation sheet 630 ranges from 10 Ω to 50 Ω.

The above-described heat dissipation sheet can be applied to other flat display apparatuses such as a LCD and a FED as well as the above-described plasma display apparatus.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. A flat display apparatus comprising:
a display panel;
a frame formed on a rear surface of the display panel; and
a heat dissipation sheet comprising a metal mixture and an adhesive, formed between the display panel and the frame.

2. The flat display apparatus as claimed in claim 1, wherein the metal mixture comprises silicon resin and a conductive material.

3. The flat display apparatus as claimed in claim 2, wherein a composition ratio of the conductive material ranges from 10% to 50% of a total composition ratio of the heat dissipation sheet.

4. The flat display apparatus as claimed in claim 3, wherein the conductive material comprises one or more of Cu, Ag, Ti, Zn, Cr, Al and Au.

5. The flat display apparatus as claimed in claim 1, wherein the metal mixture comprises urethane resin and a conductive material.

6. The flat display apparatus as claimed in claim 5, wherein a composition ratio of the conductive material ranges from 10% to 50% of a total composition ratio of the heat dissipation sheet.

7. The flat display apparatus as claimed in claim 6, wherein the conductive material comprises one or more of Cu, Ag, Ti, Zn, Cr, Al and Au.

8. The flat display apparatus as claimed in claim 1, wherein the resistance of the heat dissipation sheet ranges from 10Ω to 50Ω.

9. A flat display apparatus comprising:
a display panel;
a frame formed on a rear surface of the display panel; and
a heat dissipation sheet comprising a graphite layer and an adhesive layer,
formed between the display panel and the frame.

10. The flat display apparatus as claimed in claim 9, wherein the resistance of the heat dissipation sheet ranges from 10Ω to 50Ω.

11. A heat dissipation sheet for a flat display apparatus comprising:
a metal mixture; and
an adhesive.

12. The heat dissipation sheet for the flat display apparatus as claimed in claim 11, wherein the metal mixture comprises silicon resin and a conductive material.

13. The heat dissipation sheet for the flat display apparatus as claimed in claim 12, wherein a composition ratio of the conductive material ranges from 10% to 50% of a total composition ratio of the heat dissipation sheet.

14. The heat dissipation sheet for the flat display apparatus as claimed in claim 13, wherein the conductive material comprises one or more of Cu, Ag, Ti, Zn, Cr, Al and Au.

15. The heat dissipation sheet for the flat display apparatus as claimed in claim 11, wherein the metal mixture comprises urethane resin and a conductive material.

16. The heat dissipation sheet for the flat display apparatus as claimed in claim 15, wherein a composition ratio of the conductive material ranges from 10% to 50% of a total composition ratio of the heat dissipation sheet.

17. The heat dissipation sheet for the flat display apparatus as claimed in claim 16, wherein the conductive material comprises one or more of Cu, Ag, Ti, Zn, Cr, Al and Au.

18. The heat dissipation sheet for the flat display apparatus as claimed in claim 11, wherein the resistance of the heat dissipation sheet ranges from 10Ω to 50Ω.
